Europäisches Patentamt

European Patent Office

Office européen des brevets

(11) Publication number: 0 685 928 A1

# EUROPEAN PATENT APPLICATION

(21) Application number: 94201520.7

(51) Int. Cl.6: H03B 1/00, H03B 5/20

(22) Date of filing: 30.05.94

(43) Date of publication of application:
06.12.95 Bulletin 95/49

(84) Designated Contracting States:
BE DE ES FR GB IT NL SE

(71) Applicant: BELL TELEPHONE
MANUFACTURING COMPANY Naamloze
Vennootschap
Francis Wellesplein 1
B-2018 Antwerp (BE)

(72) Inventor: Sevenhans, Joannes Mathilda
Josephus
Prins Kavellei 126
B-2930 Brasschaat (BE)
Inventor: Sallaerts, Daniel
Dubbeekstraat 122
B-3200 Aarschot (BE)

(54) Oscillator arrangement.

(57) An oscillator arrangement is described which includes the series coupling of first (OTA1,C1) and second (OTA2,C2) integrator circuit, an output signal provided at an output of the second integrator circuit (OTA2,C2) being negatively fed back to an input of the first integrator circuit (OTA1,C1). The input impedance of the integrator circuit (OTA1,C1/OTA2,C2) have a negative value, whereby losses due to finite output resistances of the integrator circuit are compensated thereby providing a high quality factor.

FIG.3

The present invention relates to an oscillator arrangement including the series coupling of a first and a second integrator circuit providing an output signal which is negatively fed back to an input of said first integrator circuit.

Such an oscillator arrangement is already known in the art, e.g. from the book 'Analog integrated circuit design', by A. Grebene, published by Van Nostrand Reinhold Company, New York, 1972, pp. 280 - 282. Therein, each of the integrator circuit includes a series resistance connected between an input terminal and an output terminal of the integrator circuit, and a shunt capacitance connected between this output terminal and another output terminal of the integrator circuit. The output of the second integrator circuit is connected to an input terminal of an operational amplifier providing a negative gain with absolute value K, thus providing the above negative feedback, and whose output is coupled to the input terminal of the first integrator circuit via a unity gain operational amplifier. When the value of K is sufficiently high, the arrangement starts oscillating.

As follows from equation (9.7) of the above book the so-called selectivity or quality factor Q is determined by the poles of the arrangement and the value of K. This quality factor Q is a measure of the quality of the output signal, i.e. the higher Q the less noise and spurious signals are contained in the output signal. This quality factor Q is degraded when losses occur in the oscillator arrangement. Such losses are inherent due to the finite input terminal and output impedances of both the operational amplifier providing the negative gain and the unity gain operational amplifier.

To be noted that due to the negative feedback a stable DC operation is obtained.

An object of the present invention is to provide an oscillator arrangement of the above known type but with an improved quality factor.

According to the invention, this object is achieved due to the fact that at least one of said integrator circuit has an input impedance of negative value.

In this way, the latter input impedance compensates for losses due to a finite output impedance of the other integrator circuit whereby the quality factor of the arrangement is improved.

Another characteristic feature of the present invention is that said at least one integrator circuit includes a first transistor whose base electrode is coupled to an input terminal of said at least one integrator circuit, and whose emitter electrode is coupled to a DC supply terminal of a DC voltage supply source via a capacitive impedance means.

Thereby, provided the frequency of oscillation fosc of the oscillator arrangement is sufficiently high, i.e. of the order of magnitude of the so-called cut-off frequency $f_T$ of the first transistor, the input impedance seen at the base electrode thereof indeed has a negative value approximately equal to

$$-\frac{f_T}{fosc} \times Z_c$$

where fosc is the frequency of oscillation and $-j \times Z_c$ is the impedance value of the capacitive impedance means.

A further characteristic of the present invention is that said capacitive impedance means includes a second transistor whose base electrode is coupled to said emitter electrode of said first transistor and whose emitter electrode is coupled to said DC supply terminal.

In this way, when the frequency of oscillation is sufficiently high, the input impedance of the second transistor seen at the base electrode thereof has a negative imaginary part and thus operates as a capacitance, whereby the input impedance of the first transistor has a negative value.

Still another feature of the present invention is that said integrator circuit includes an operational transconductance amplifier.

This operational transconductance amplifier increases the loop gain of the arrangement without introducing significant additional losses since both its input and output impedances have a large value and therefore only produce a small degradation of the quality factor Q.

Yet a further feature of the present invention is that said operational transconductance amplifier includes an emitter coupled pair, each of both transistors thereof being constituted by a said second transistor and being preceded by a said first transistor whose base electrode is coupled to a respective input terminal of said operational transconductance amplifier, the output terminals of said operational transconductance amplifier being coupled to a second DC supply terminal of said DC voltage source via respective impedance means.

2

In this way, the operational transconductance amplifier is a differential amplifier with a negative input impedance and negative feedback may simply be provided in the oscillator arrangement by cross-coupling the differential outputs of one operational transconductance amplifier with the respective differential inputs of a second operational transconductance amplifier.

An even further feature of the present invention is that said respective impedance means include active impedance means said operational transconductance amplifier further includes first and second controllable current sources coupled between the junction point of said transistors of said emitter coupled pair and said respective impedance means on the one hand, and said first DC supply terminal on the other hand.

In this way, the gain of the operational transconductance amplifier may be controlled by controlling the current provided by the controllable current sources. Indeed, the latter current determines the current flowing through the active impedance means of the emitter coupled pair and thereby the so-called transconductance $g_m$ of both of these active impedance means and thus the gain of the operational transconductance amplifier.

A still further characteristic of the present invention is that each of said respective impedance means includes the series connection of first and second load resistances, and that said operational transconductance amplifier further includes a second emitter coupled pair whose input terminals are coupled to respective output terminals of said first emitter coupled pair and whose outputs are cross-coupled to respective junction points of said first and second load resistances.

Thus, the value of the impedance means is significantly increased. Indeed, when the second emitter coupled pair is so designed as to provide a unity gain, then the voltage at the junction point of the first and second load resistances changes in the same way as that on the corresponding input terminal of the second differential pair, i.e. the AC voltage across the second load impedance is zero and no AC current flows therethrough. Thus, for an AC voltage present at either of the inputs of the second emitter coupled pair no AC current flows through this second load impedance which therefore no longer imposes a load on the oscillator arrangement.

The above mentioned and other objects and features of the invention will become more apparent and the invention itself will be best understood by referring to the following description of an embodiment taken in conjunction with the accompanying drawings wherein :

Fig 1 shows an oscillator arrangement according to the invention;

Fig 2 represents an equivalent circuit of the oscillator arrangement of Fig 1; and

Fig 3 shows an operational transconductance amplifier OTA used in the oscillator arrangement of Fig 1.

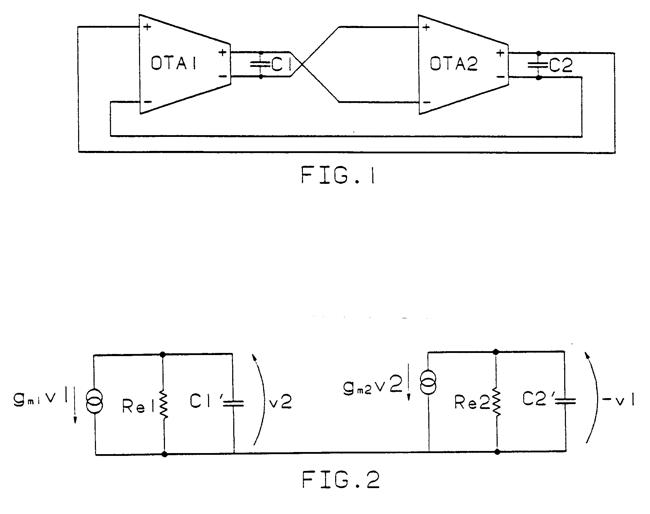

The oscillator arrangement shown in Fig 1 includes first and second differential operational transconductance amplifiers OTA1 and OTA2, the differential outputs of OTA1 being cross-coupled to the differential inputs of OTA2, i.e. the positive output (+) of OTA1 to the negative input (-) of OTA2 and the negative output (-) of OTA1 to the positive input (+) of OTA2. The differential outputs of OTA2 are coupled to the differential inputs of OTA1, positive (+) to positive (+) and negative (-) to negative (-). Thus, a phase shift of $\pi$ is provided for both DC and AC, whereby a stable DC bias is obtained. For AC an additional phase shift of $\pi$ is provided by capacitances C1 and C2 connected across the outputs of OTA1 and OTA2 respectively, as each capacitance provides an additional phase shift of $\pi/2$. The operational transconductance amplifiers OTA1 and OTA2 together with their respective output capacitances C1 and C2 each operate as an integrator circuit providing an output voltage VOUT equal to

$$\mathrm{VOUT} = \frac{g_m}{C} \times \int_{t_0}^{t} \mathrm{VIN}\ dt$$

where VIN is the input voltage and $g_m$ the so-called transconductance of the respective operational transconductance amplifier, and C is the value of the respective output capacitance, i.e. C1 or C2.

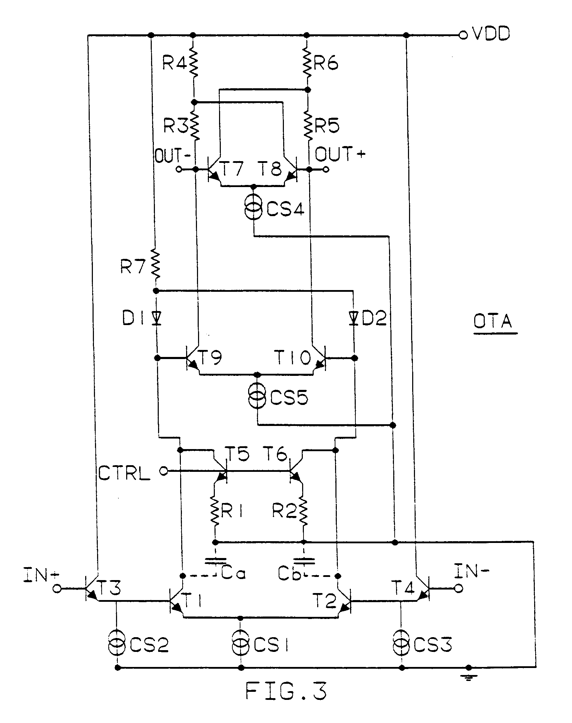

The value of the oscillation frequency may be determined with the aid of the AC equivalent half-circuit shown in Fig 2. This circuit includes a first current source, providing a current $g_{m1}v1$, in parallel with a resistance Re1 and a capacitance C1', as well as a second current source, providing a current $g_{m2}v2$, in parallel with a resistance Re2 and a capacitance C2'. Herein, $g_{m1}$ and $g_{m2}$ are the respective transconductance values of OTA1 and OTA2, v1 is the opposite of the voltage developed across C2', v2 is the voltage developed across C1', C1' is an equivalent capacitance corresponding to output capacitance C1 in parallel with the input capacitance of OTA2, whereas C2' is an equivalent capacitance corresponding to capacitance C2 in parallel with the input capacitance of OTA1, Re1 is an equivalent resistance corresponding to the parallel connection of the output resistance of OTA1 and the input resistance of OTA2 are combined, as Re2 is an equivalent resistance corresponding to the parallel connection of the output resistance of OTA2 and the input resistance of OTA1.

One can easily show that the following second order differential equation applies.

$$\frac{d^2 v1}{dt} + \left(\frac{1}{C1 \times R1} + \frac{1}{C2 \times R2}\right)\frac{dv1}{dt} + \left(\frac{1}{C1 \times C2 \times R1 \times R2} + \frac{g_{m1} \times g_{m2}}{C1 \times C2}\right)v1 = 0$$

From this equation one may, in the way described for instance in the above mentioned book in paragraph 9.2, easily derive the oscillation frequency fosc and the quality factor Q of the oscillator arrangement.

$$fosc = \frac{1}{2\pi}\sqrt{\frac{1}{C1' \times C2' \times Re1 \times Re2} + \frac{g_{m1} \times g_{m2}}{C1' \times C2'}}$$

$$Q = \frac{\dfrac{1}{\sqrt{C1' \times C2'}}\sqrt{\dfrac{1}{Re1 \times Re2} + g_{m1} \times g_{m2}}}{\dfrac{1}{C1' \times Re1} + \dfrac{1}{C2' \times Re2}}$$

Thus, it is clear that the higher are the equivalent resistances Re1 and Re2, the higher is the quality factor Q. However, the output resistances of the operational transconductance amplifiers can only be increased to a limited extent since too large an output resistance would cause too strong a decrease of the DC bias at the outputs of these amplifiers. Therefore, the finite value of the output resistance of the amplifiers OTA1 and OTA2 is compensated by a negative value of the input resistance of OTA2 and OTA1, respectively. Furthermore, the value of the output resistance of OTA1 and OTA2 for AC signals present on the outputs is increased by a bootstrapping technique as described hereinafter with reference to Fig 3.

Each of the amplifiers OTA1 and OTA2 is built as an operational transconductance amplifier OTA shown in Fig 3. OTA includes between a positive supply terminal VDD and a ground terminal of a DC voltage supply source, a first branch including the series connection of a resistance R7, a diode D1, the collector emitter path of a transistor T1 and a current source CS1, a second branch including the series connection of the resistance R7, a diode D2, the collector emitter path of a transistor T2 and the current source CS1, a third branch including the series connection of the collector emitter path of a transistor T3 and a current source CS2, a fourth branch including the series connection of the collector emitter path of a transistor T4 and a current source CS3, a fifth branch including the series connection of resistances R4 and R3, the collector emitter path of a transistor T9 and a current source CS5, and a sixth branch including the series connection of resistances R6 and R5, the collector emitter path of a transistor T10 and the current source CS5. The base electrodes of transistors T3 and T4 constitute respective positive and negative inputs IN+ and IN- of OTA. The emitter of T3 is connected to the base of T1, whilst the emitter of T4 is connected to the base of T2. The base of transistor T9 is connected to the collector of T1, whereas the base of T10 is connected to the collector of T2. The collector of T1 is coupled to the ground terminal via the series connection of the collector emitter path of a transistor T5 and a resistance R1, whereas the collector of T2 is coupled to the ground terminal via the series connection of the collector emitter path of a transistor T6 and a resistance R2. The combination of T5 and R1, as well as that of T6 and R2 both constitute a current source whose current is controlled by the voltage at a control input CTRL connected to the base electrodes of both T5 and T6. The junction point of resistances R3 and R4 is coupled to the ground terminal via the series connection of the collector emitter path of a transistor T8 and a current source CS4, whereas the junction point of resistances R5 and R6 is coupled to the ground terminal via the series connection of the collector emitter path of a transistor T7 and the current source CS4. The base electrodes of T7 and T8 are connected to the collector electrodes of T9 and T10, respectively. The collector electrodes of T9 and T10 are connected to respective negative and positive output terminals OUT- and OUT+ of OTA.

The capacitances C1 and C2 are not included as discrete components in OTA but are constituted by parasitic collector bulk capacitances Ca and Cb of the transistors T1 and T2, respectively. Thus, each of the capacitances C1 and C2 is provided as the series coupling, via the collector base paths of T9/T10 and the ground terminal, of a capacitance Ca and a capacitance Cb. The capacitances Ca and Cb are shown connected in dotted lines in Fig 3.

To be noted that transistors T1 to T10 are all bipolar npn-type transistors.

The operation of the operational transconductance amplifier OTA described hereinafter will show that OTA has a negative input impedance and will clarify the above mentioned bootstrapping technique.

A differential input voltage applied across the inputs IN+ and IN- is amplified and gives rise to a differential current through the diodes D1 and D2, and thereby to a differential voltage between the base electrodes of transistors T9 and T10. This in its turn gives to a differential output voltage across the outputs OUT+ and OUT-. The gain of the operational transconductance amplifier OTA is thus determined by the transconductances of transistors T1 and T2, and by those of T9 and T10, but also by the conductances of diodes D1 and D2 as these determine the ratio between the differential current through D1 and D2 and the differential voltage across the base electrodes of T9 and T10. These conductances are equal to equal to $g_D = \frac{ID}{Vt}$, wherein I is the DC current through the respective diode and

$$Vt = \frac{k \times T}{q}$$

in which k is Boltzmann's constant, T is the absolute temperature in K and q is the electron charge. Thus, the gain of OTA may be adapted by changing the current ID through diodes D1 and D2 which is equal to the current delivered by current source CS1 plus the current delivered by transistors T5 and T6. Hence, the gain of OTA may be controlled by a control voltage Vctr on the control input CTRL connected to the base electrodes of T5 and T6. Indeed, this control voltage Vctr determines the DC current Ictr conducted by both transistors T5 and T6 which is approximately equal to

$$Ictr = \frac{Vctr - Vbe}{R12},$$

where Vbe is the base emitter voltage drop of T5 or T6 which is approximately equal to 0.7 volts, and R12 is the value of resistance R1 or R2 whose values are assumed to be equal. In this way, part of the DC current flowing through diodes D1 and D2 may be adapted, whereby the gain of OTA is adapted.

The input impedance of OTA may be determined as follows. The input impedance Zi seen at the base electrode of a transistor whose emitter is coupled to the ground terminal via an impedance Ze, may be shown to be equal to

$$Zi = \frac{(1 + g_m \times Ze) \times R\pi}{1 + j \times 2\pi \times fosc \times R\pi \times C\pi} + Ze,$$

wherein $g_m$ is the transconductance of OTA, $R\pi$ is the base emitter resistance and $C\pi$ the base emitter capacitance of the latter transistor, and fosc is the above frequency of oscillation. Thus, in a first approximation when fosc is of the order of magnitude of the so-called cut-off frequency $f_T$ which is equal to

$$f_T = \frac{1}{2\pi} \frac{g_m}{C\pi},$$

then

$$Zi = -j \frac{f_T}{f} \times Ze.$$

Hence, the input impedance ZiOTA of OTA is then equal to

5

$$ZiOTA = -\left(\frac{f_T}{f}\right)^2 \times Rcs$$

wherein Rcs now is the output resistance of current source CS1 for differential mode operation of OTA and ZiOTA clearly has a negative value. Thus, the negative input resistance of OTA1 compensates for the finite output resistance of OTA2, as the negative input resistance of OTA2 compensates for the finite output resistance of OTA1. To be noted that the output resistances of current sources CS2 and CS3 are neglected in this calculation, i.e. they are assumed to be infinite.

The AC value of the output impedance of OTA is increased by the already mentioned bootstrapping technique as now described hereafter. The differential pair constituted by transistors T7 and T8 and current source CS4 is so designed that its gain is equal to unity. As a consequence, a differential output voltage Vout across output terminals OUT+ and OUT- gives rise to an equal differential voltage between the collectors of T7 and T8, respectively. Thereby, the AC voltage across resistance R3 as well as that across R5 is zero and no AC current flows therethrough. Hence, the series coupling of R4 and R3, as well as that of R6 and R5, constitute an infinite AC impedance for a differential AC voltage present across output terminals OUT+ and OUT-.

While the principles of the invention have been described above in connection with specific apparatus, it is to be clearly understood that this description is made only by way of example and not as a limitation on the scope of the invention.

**Claims**

1. Oscillator arrangement including the series coupling of a first (OTA1,C1) and a second (OTA2,C2) integrator circuit providing an output signal which is negatively fed back to an input of said first integrator circuit (OTA1,C1), characterized in that at least one of said integrator circuit (OTA1,C1/OTA2,C2) has an input impedance of negative value.

2. Oscillator arrangement according to claim 1, characterized in that said at least one integrator circuit (OTA,Ca,Cb) includes a first transistor (T3/T4) whose base electrode is coupled to an input terminal (IN+/IN-) of said at least one integrator circuit (OTA,Ca,Cb), and whose emitter electrode is coupled to a DC supply terminal of a DC voltage supply source via a capacitive impedance means (T1,CS1/T2,CS2).

3. Oscillator arrangement according to claim 2, characterized in that said capacitive impedance means (T1,CS1/T2,CS2) includes a second transistor (T1/T2) whose base electrode is coupled to said emitter electrode of said first transistor (T3/T4) and whose emitter electrode is coupled to said DC supply terminal.

4. Oscillator arrangement according to claim 1, characterized in that said integrator circuit (OTA1,C1/OTA2,C2/ OTA,Ca,Cb) includes an operational transconductance amplifier (OTA1/OTA2/OTA).

5. Oscillator arrangement according to claims 3 and 4, characterized in that said operational transconductance amplifier (OTA,Ca,Cb) includes an emitter coupled pair (T1,T2,CS1), each of both transistors (T1,T2) thereof being constituted by a said second transistor (T1,T2) and being preceded by a said first transistor (T3,T4) whose base electrode is coupled to a respective input terminal of said operational transconductance amplifier (OTA,Ca,Cb), the output terminals of said operational transconductance amplifier (OTA,Ca,Cb) being coupled to a second DC supply terminal (VDD) of said DC voltage source via respective impedance means (D1,R7/D2,R7).

6. Oscillator arrangement according to claim 5, characterized in that said respective impedance means (D1,R7/D2,R7) include active impedance means (D1,D2) said operational transconductance amplifier (OTA,Ca,Cb) further includes first (T5,R1) and second (T6,R2) controllable current sources coupled between the junction point of said transistors (T1/T2) of said emitter coupled pair and said respective impedance means (D1,R7/D2,R7) on the one hand, and said first DC supply terminal on the other hand.

7. Oscillator arrangement according to claim 6, characterized in that said controllable current sources (T5,R1/T6,R2) each include the series coupling of a collector emitter path of a third transistor (T5/T6) and a resistance (R1/R2) between said junction point and said first DC supply terminal, the base electrode of said third transistor (T5/T6) constituting a control input for said controllable current source (T5,R1/T6,R2).

8. Oscillator arrangement according to claim 5, characterized in that each of said respective impedance means (R3,R4/R5,R6) includes the series connection of first (R4/R6) and second (R3/R5) load resistances, and that said operational transconductance amplifier further includes a second emitter coupled pair (T7,T8,CS4) whose input terminals are coupled to respective output terminals (OUT+,OUT-) of said first emitter coupled pair and whose outputs are cross-coupled to respective junction points of said first (R4/R6) and second load resistances (R3/R5).

FIG. 1

FIG.2

FIG.3

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-4 760 353 (G.W. PERKINS) * column 1, line 56 - column 4, line 18; figures 1-3 * | 1,4 | H03B1/00 H03B5/20 |
| X | ELECTRONICS LETTERS, vol.2, no.2, February 1966, LONDON page 52 R.L. FORD 'ACTIVE FILTERS AND OSCILLATORS USING SIMULATED INDUCTANCE' * the whole document * | 1,4 | |
| A | US-A-4 417 215 (L.L. KLEINBERG) * column 4, line 28 - column 4, line 65; figure 2 * | 1 | |
| A | DE-A-38 03 179 (TOSHIBA) | | |
| A | US-A-5 185 581 (A.K.D. BROWN) | | |

TECHNICAL FIELDS SEARCHED (Int.Cl.6)

H03B

The present search report has been drawn up for all claims

| Place of search | Date of completion of the search | Examiner |
|---|---|---|
| THE HAGUE | 27 October 1994 | Dhondt, I |

EPO FORM 1503 03.82 (P04C01)